(19) **Europäisches Patentamt**

**European Patent Office**

**Office européen des brevets**

(11) **EP 1 239 625 B1**

(12) **EUROPÄISCHE PATENTSCHRIFT**

(45) Veröffentlichungstag und Bekanntmachung des Hinweises auf die Patenterteilung:
**14.06.2006 Patentblatt 2006/24**

(51) Int Cl.:
*H04L 7/00* (2006.01)     *H04B 7/26* (2006.01)

(21) Anmeldenummer: **02100155.7**

(22) Anmeldetag: **20.02.2002**

(54) **Empfänger und Verfahren zum anfänglichen Synchronisieren eines Empfängers auf die Trägerfrequenz eines gewünschten Kanals**

Receiver and method for an initial synchronizing of the receiver to the carrierfrequency of a desired channel

Récepteur et procédé pour synchroniser initialement le récepteur à la fréquence porteuse d'un canal desiré

(84) Benannte Vertragsstaaten:
**AT BE CH CY DE DK ES FI FR GB GR IE IT LI LU MC NL PT SE TR**

(30) Priorität: **21.02.2001 DE 10108110**

(43) Veröffentlichungstag der Anmeldung:
**11.09.2002 Patentblatt 2002/37**

(73) Patentinhaber:
• **Philips Intellectual Property & Standards GmbH 20099 Hamburg (DE)**
Benannte Vertragsstaaten:
**DE**
• **Koninklijke Philips Electronics N.V. 5621 BA Eindhoven (NL)**

(72) Erfinder:
• **Kalveram, Hans, Dr.-Ing.**
**c/o Philips Corp.Int.Prop**
**52066 Aachen (DE)**
• **Reuter, Thomas,**
**c/o Philips Corp.Int.Prop. GmbH**
**52066 Aachen (DE)**

(74) Vertreter: **Volmer, Georg et al**
**Philips Intellectual Property & Standards GmbH,**
**Postfach 50 04 42**
**52088 Aachen (DE)**

(56) Entgegenhaltungen:
**EP-A- 0 726 662     EP-A- 0 946 010**
**EP-A- 1 024 624     US-A- 6 006 078**

**Beschreibung**

Die Erfindung bezieht sich auf einen Empfänger, insbesondere einen Global System for mobile communication GSM-Empfänger mit Anfangssynchronisation, und ein entsprechendes Verfahren zum Empfang eines analogen Signals mit einer gewünschten Trägerfrequenz gemäß dem Oberbegriff der Patentansprüche 1 und 6.

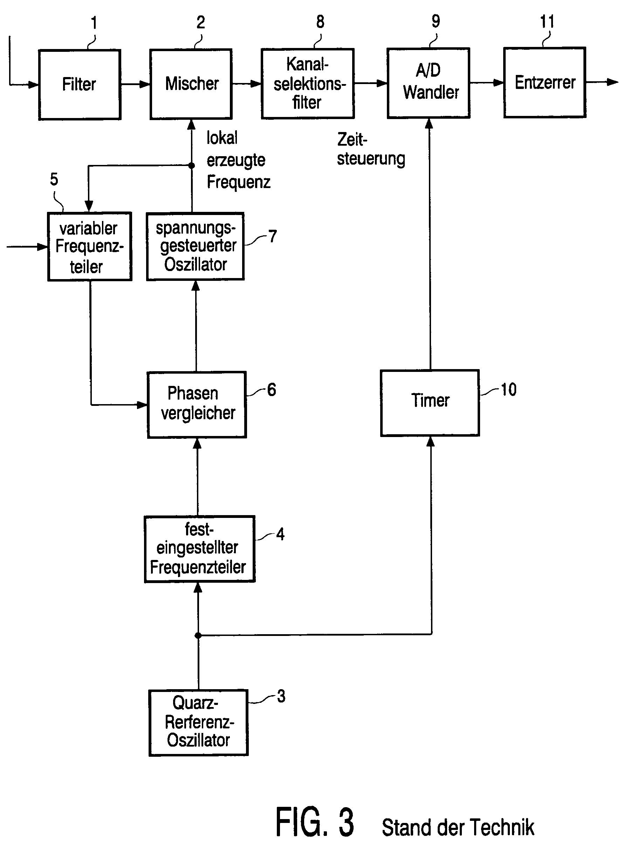

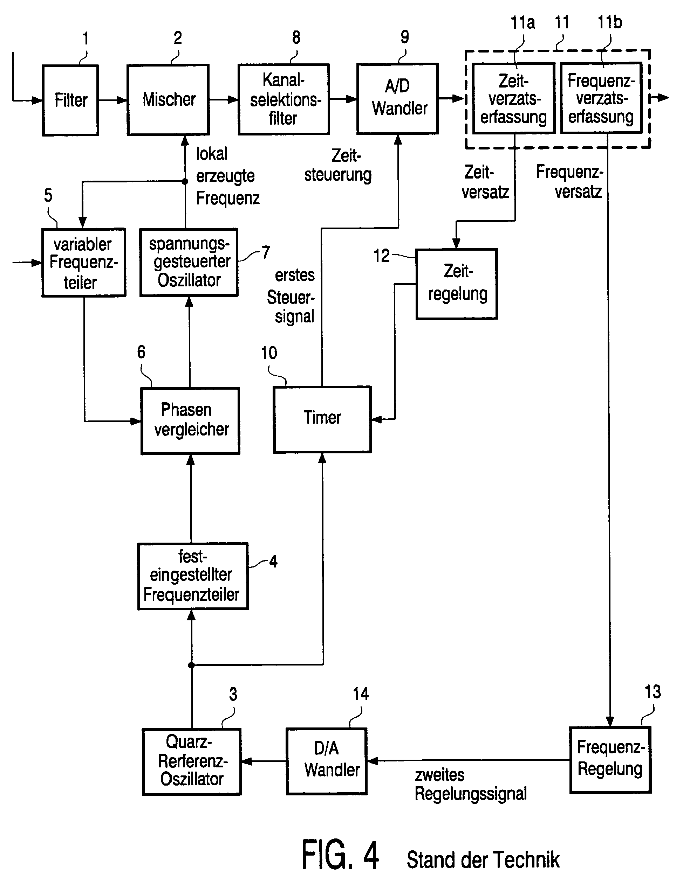

Ein derartiger Empfänger und ein derartiges Verfahren sind aus dem Stand der Technik bekannt und werden nachfolgend anhand von Fig 3 und 4 näher beschrieben. Sie sind beispielsweise in G. Frank, W. Koch, "Initial Synchronisation of a mobile station in the D-net", PKI Tech. Jour. 1/1990 S.43-49 veröffentlicht.

Gemäß Fig 3 wird mit einer nicht gezeigten Antenne eine Vielzahl von Funkkanälen empfangen, auf denen Signale von einer oder mehreren Basisstationen empfangen werden. Beispielsweise handelt es sich bei den empfangenen Kanälen um GSM-Kanäle mit einem Abstand der Trägerfrequenzen von 200 kHz. In einem festen Empfangsfilter 1 werden zunächst außerhalb der in Frage kommenden Eingangskanäle liegende Frequenzen unterdrückt, so dass am Ausgang des Filters 1 ein Bandpass-Signalgemisch bereitgestellt wird. Dieses Bandpass-Signalgemisch wird durch einen Mischer 2 mit Hilfe einer lokal erzeugten Frequenz in ein komplexes Basisbandsignal heruntergemischt, welches aus einer In-Phase und einer Quadraturkomponente besteht. Zur Erzeugung der lokalen Frequenz wird auf Basis eines Quarzreferenzoszillators 3 eine Phasenregelschleife 4 bis 7 betrieben, welche aus einem festen Frequenzteiler 4 zum Teilen der Referenzfrequenz, einem variablen Frequenzteiler 5 zum Teilen der lokal erzeugten Frequenz, einem Phasenvergleicher 6 und einem spannungsgesteuerten Oszillator 7 besteht.

Der variable Frequenzteiler 5 weist einen separaten Eingang - in Fig 3 und 4 durch den separaten Pfeil gekennzeichnet - auf, mit welchem ein zu empfangener Wunschkanal, dh insbesondere dessen Frequenz voreingestellt werden kann.

Aus dem komplexen Basisbandsignal am Ausgang des Mischers 2 wird mit einem nachgeschalteten Kanalselektionsfilter, zB. einem Tiefpass, ein Empfangskanal herausgefiltert; das Ausgangssignal des Kanalselektionsfilters 8 wird nachfolgend als Mischsignal bezeichnet.

Entspricht die im spannungsgesteuerten Oszillator 7 erzeugte lokale Frequenz näherungsweise der Trägerfrequenz eines der im Funksignal aufgetretenen Kanäle, so wird der zugehörige Funkkanal empfangen. Das Kanalselektionsfilter 8 ermöglicht auch die Abtastung des Mischsignals in einem nachgeschalteten Analog-/Digitalwandler 9.

Die durch den Quarz-Refepenzoszillator 3 erzeugte Referenzfrequenz wird nicht nur zur Erzeugung der lokalen Frequenz am Ausgang des spannungsgesteuerten Oszillators verwendet, sondern legt über einen Timer 10 auch den Anfangszeitpunkt für den Empfang eines Zeitschlitzes und die in dem A/D-Wandler 9 verwendeten Abtastzeitpunkte fest.

Damit ist die Zeitbasis des Funkempfängers direkt an die Frequenzbasis gekoppelt.

Das Signal eines Funkkanals ist zur digitalen Übertragung zB. unter Verwendung von Gussian Minimum Shift Keying GMSK moduliert und durch die mobile Funkübertragung u.a. durch Mehrwegeausbreitung beeinträchtigt.

Der Datenstrom besteht beispielsweise im GSM-System aus einer Folge von Zeitschlitzen in die an bekannten Positionen Trainingssequenzen eingefügt sind, die eine Schätzung der momentanen Kanaleigenschaften erlauben.

In einem Entzerrer 11 werden durch Konetation mit der Trainingsaequonz die Kanaleigenschaften geschätzt und das Empfangssignal eines Zeitschlitzes unter Berücksichtigung der Intersymbol-Interlerenz demoduliert. An seinem Ausgang stellt der Entzerrer 11 die Nutzinformation aus dem über die Antenne empfangenen Funksignal für eine vetere Bearbeitung bereit.

Fig 4 zeigt eine praxisnähere Ausgestaltung des Empfängers gemäß Fig 3, welche sich lediglich durch eine zusätzliche Zeitregelung 12 und eine zusätzliche Frequenzregelung 13 von der Ausgestaltung gemäß Fig. 3 unterscheidet.

Gemäß Fig 4 weist der Entzerrer 11 eine Zeitversatz-Erfassungseinrichtung 11 a zum Erfassen eines Zeitversatzes sowie eine Frequenzversatz-Erfassungseinrichtung zum Erfassen eines Frequenzversatzes in dem Empfangssignal auf. Dabei bezieht sich der Zeitversatz auf den Einschaltzeitpunkt des A/D-Wandlers 9 zu Beginn eines Zeitschlitzes und der quenzversatz auf die Trägerfrequenz 0 des komplexen Basisbandsignals.

Anders ausgedrückt, repräsentiert der Zeitvesatz eine Zeitdifferenz zwischen einem erwarteten und einem tatsächlichen Empfangszeitpunkt einer Testsequenz in dem empfangenen Signal. Dabei berechnet sich der erwartete Empfangszeitpunkt als Zeitdifferenz zwischen einem durch das Steuersignal mrgegebenen Anfangszeitpunkt, welcher die Zeitbasis definiert und dem im GSM-System vordefinierten Zeitabstand zwischen zwei aufeinanderfolgenden Testsequenzen.

Der in der Zeitversatz-Erfassungseinrichtung 11a erfasste Zeitversatz wird von der Zeitregelung 12 ausgewertet und zur Erzeugung eines ersten Regelungssignals verwendet. Dieses erste Regäungssignal dient zum Regeln des Timers und damit zur Verstellung des Anfangszeitpunktes für den Empfang zukünftiger Zeitschlitze in dem A/D-Wandler 9.

Die Zeitversatzerfassung 11, einer Zeihegelung 12 und einem Timer 10, der ein erstes Steuersignal zur laufenden Festlegung der Abtastzeitpunkte an den A/D-Wandler 9 gibt, bilden zusammen eine Synchronisationsschaltung zur Regeneration des Symboltaktes.

Der Frequenzversatz wird, nachdem er durch die Einrichtung 11b erfasst wurde, der Frequenzregelung 13 zugeführt, welche auf Basis dieses Frequenzversatzes ein zweites Regelungssignal zur Nachführung des Quarz-Referemoszillators 3 über einen Digital/Analog-Wandler 14 bereitstellt. Auf diese Weise wird die im Oszillator 7 erzeugte lokale Frequenz mit der Trägerfrequenz des empfangenen gewünschten Kanals in Einklang gebracht.

Der Aufbau eines Funkempfangs beginnt in der Regel mit dem Absuchen eines Frequenzbandes nach Kanälen mit starken Signalen und einer Anfangseynchronisation auf das stärkste Signal. Um einen bestimmten Kanal zu empfangen, wird der variable Frequenzteiler 5 über den separaten Eingang so voreingestellt, dass er die bekannte Trägerfrequenz des gewünschten Kanals mit der durch den fest eingestellten Frequenzteiler 4 heruntergeteilten Nominalfrequenz des Quarzreferenzoszillators 3 in Übereinstimmung bringt.

Zunächst wird der Funkempfänger mit einer willkürlich gewählten Steuergröße aus dem A/D-Wandler 14 zu einem beliebigen Zeitpunkt in Betrieb genommen. Zu Beginn des Aufbaues des Funkempfangs werden anstelle des Entzerrers 11 Pegelmessungen durchgeführt und für einen Kanal mit starkem Empfangspegel schließlich Zeit- und Frequenz schätzverfahren mit einem größeren Fangbereich zur Anfangssynchronisation eingesetzt. Nachdem die Zeitregelung 12 und die Frequenzregelung 13 nur noch geringe Abweichungen feststellen, wird auf Datenempfang mit dem zuvor beschriebenen Entzerrer 11 übergegangen.

Dem in den Fig. 3 und 4 beschriebenen Empfänger haftet der Nachteil an, dass in dem Fall, dass ein Quarz-Referenzoszillator mit schlechter initialer Frequenzgenauigkeit verwendet wird, der Aufbau des Funkempfangs erschwert ist. Die Voreinstellung des festen Frequenzteilers 5 auf einen gewünschten Empfangskanal kann bei schlechter initialer Frequenzablage des Quarzreferenzoszillators 3 dazu führen, dass die lokal erzeugte Frequenz am Ausgang des Oszillators 7 nicht der Trägerfrequenz des gewünschten Kanals, sondern der Trägerfrequenz eines benachbarten Kanals entspricht. Dann wird von dem Mischer 2 und dem Kanalselektionsfilter 8 anstelle des gewünschten Kanals dessen Nachbarkanal empfangen. Da jedoch sowohl die Anfangssynchronisation als auch die Entzerrung 11 dieses Signal erfolgreich auswerten können und keinen Frequenzversatz feststellen, kann auch die Frequenzregelung diese Frequenzablage des Referenzoszillators 3 nicht ausregeln.

Trotz des Empfangs des unerwünschten Nachbarkanals kann das Empfangssignal durch Verstellen des veränderlichen Frequenzteilers 5 und des zweiten Regelsignals systematisch nach starken Signalen abgesucht werden. Darüber hinaus können auch bekannte Verfahren der Anfangssynchronisation und Entzerrung eingesetzt werden, ohne dass die wirkliche Trägerfrequenz des Empfangssignals bekannt ist. In diesem Fall wird zwar die richtige Trägerfrequenz des gewünschten Kanals als lokale Frequenz am Ausgang des spannungsgesteuerten Oszillators 7 erzeugt, jedoch basiert diese richtige Einstellung auf einer gleichzeitigen Fehleinstellung des variablen Frequenzteilers 5 und des Quarzreferenzoszillators 3.

Genauer gesagt, weicht die Einstellung des variablen Frequenzteilers 5 von der in bezug auf die Nominalfrequenz des Referenzoszillators 3 richtigen Einstellung ab.

Mathematisch lässt sich diese Situation wie folgt veranschaulichen:

$$fHF = n^*fph \qquad \rightarrow \text{richtiges timing}$$
$$= (n+1)^*(fph - df) \qquad \rightarrow \text{falsches timing}$$
$$= (n-1)^*(fph + df) \qquad \rightarrow \text{falsches timing}$$

wobei gilt:

fHF = "richtige" Frequenz des spannungsgesteuerten Oszillators

fph = Phasenvergleichsfrequenz (bei GSM typischerweise 200 kHz)

df = Abweichung (Fehler der Phasenvergleichsfrequenz

n = "richtiger" Teilungsfaktor des variablen Frequenzteilers

Wurde als Teilerverhältnis n+1 oder n-1 gewählt, so kann ein passender Fehler des Referenzoszillators 3 zu einer korrekten Frequenz des spannungsgesteuerten Oszillators VCO 7 führen.

Die Frequenz des VCO 7 ist immer ein Vielfaches der Phasenvergleichsfrequenz, welche bei GSM-Systemen typischerweise 200 kHz beträgt. Die Phasenvergleichsfrequenz wird in dem Empfänger durch eine geeignete Teilung der Referenzfrequenz mit Hilfe des fest eingestellten Frequenzteilers 4 gewonnen. Auf diese Weise werden VCO-Frequenzen bei GSM-System von ca. 900 oder 1800 MHz erzeugt.

Wie bereits oben angedeutet, wird aufgrund der richtig erzeugten lokalen Frequenz kein Frequenzversatz festgestellt und somit kann der Frequenzversatz nicht als Indikator für eine gleichzeitige FeHenstdlung des variablen Frequenzteilers 5 und des Referenzoszillators 3 dienen.

Die von dem Referenzoszillator 3 erzeugte Referenzfrequenz dient jedoch nicht nur zur Erzeugung der lokalen Frequenz, sondern auch zur Ansteuerung des Timers und damit zur Erzeugung des ersten Steuersignals. Diese Doppelfunktion der Referenzfrequenz wurde oben als starre Kopplung zwischen der Zeitbasis und der Referenzfrequenz bezeichnet.

Ein qualitativ schlechter Referenzoszillator mit initialer Frequenzablage, d.h. dessen Frequenz deutlich von der Nominalfrequenz abweicht, verursacht jedoch über die Ansteuerung des Timers 10 Zeitverschiebungen in den Abtastzeitpunkten des A/D-Wandlers 9, welche über das erste Steuersignal von dem Timer 10 vorgegeben werden. Diese Zeitverschiebungen sind im Vergleich zur Länge der empfangenen Zeitschlitze sehr gering und fallen daher im Hinblick auf die Leistungsfähigkeit der im Entzerrer 11 verwendeten Algorithmen kaum ins Gewicht. Im übrigen besteht die Möglichkeit, diese Verschiebungen im Entzerrer 11 zu schätzen und zu kompensieren.

Sobald diese Zeitverschiebungen jedoch einen gewissen Schwellenwert überschreiten, sind von ihnen verursachte Auswirkungen insbesondere über längere Zeitintervalle von ca. 50 ms hinweg deutlich wirksam. Die Auswirkungen treten zB. zwischen den im GSM-System von allen Basisstationen in einem regelmäßigen Zeitraster gesendeten Synchronisationsmeldungen auf.

Ausgehend von diesem Stand der Technik ist es die Aufgabe der vorliegenden Erfindung, den oben beschriebenen, aus dem Stand der Technik bekannten, Empfänger und ein zugehöriges Verfahren in der Weise weiterzubilden, dass eine gleichzeitige Fehleinstellung von variablem Frequenzteiler und Referenzfrequenz auch bei Verwendung von preisgünstigen Referenzoszillatoren mit initialer Frequenzablage und die daraus resultierenden negativen Auswirkungen von Zeitverschiebungen vermieden werden.

Diese Aufgabe wird für den beschriebenen Empfänger dadurch gelöst, dass er zusätzlich ausweist:

eine Vergleichereinrichtung zum Empfangen des Ausgangssignals der Zeitversatz-Erfassungseinrichtung, zum Feststellen, ob der Zeitversatz einen vorgegebenen Schwellenwert überschreitet und zum Ausgeben eines entsprechenden Informationssignals; und

eine Auswerteeinrichtung zum Berechnen und Ausgeben einer korrigierten Referenzfrequenz in Form eines zweiten Steuersignals über einen D/A-Wandler (14) an den Referenzoszillator (3) und zum Berechnen und Ausgeben eines korrigierten Teilerverhältnisses in Form eines dritten Steuersignals an die variable Frequenzteilerschaltung, so dass der Referenzoszillator auf die korrigierte Referenzfrequenz und die Frequenzteilerschaltung auf das korrigierte Teilerverhältnis eingestellt sind, wobei die Berechnung und Ausgabe der korrigierten Referenzfrequenz und des korrigierten Teilerverhältnisses nur dann erfolgt, wenn der Zeitversatz nach Maßgabe durch das Informationssignal den Schwellenwert überschreitet.

Diese erfindungsgemäße Ausgestaltung des Empfängers hat den Vorteil, dass zur Erzeugung der Referenzfrequenz preisgünstige Referenzoszillatoren verwendet werden können, an deren Referenzfrequenz nur geringe Genauigkeitsanforderungen gestellt werden. Diese geringen Genauigkeitsanforderungen an die Referenzfrequenz erlauben insbesondere die Verwendung von preisgünstigen Quarzen, für bestimmte Anwendungen kann sogar ganz auf die Verwendung von Quarzen verzichtet werden. Weiterhin machen die geringen Genauigkeitsanforderungen an die Referenzfrequenz des Empfängers auch die Verwendung von kostenintensiven Temperaturkompensationsschaltungen und zeitaufwendige Abgleichvorgänge entbehrlich.

Gemäß einem ersten Ausführungsbeispiel der Erfindung ist es vorteilhaft, den beschriebenen Zeitversatz durch Verwendung einer Zeitregelungseinrichtung zu kompensieren, wobei die Zeitregelungseinrichtung vorteilhafterweise ein Regelungssignal für den Timer nach Maßgabe durch das Ausgangssignal der Zeitversatz-Erfassungseinrichtung erzeugt.

Es ist weiterhin von Vorteil, wenn die Zeitregelungseinrichtung das Regelungssignal für den Timer unter zusätzlicher Berücksichtigung des von der Auswerteeinrichtung ausgegebenen zweiten Steuersignals erzeugt. In diesem Fall kann bei der Zeitregelung eine über das zweite Steuersignal neu eingestellte Referenzfrequenz als Eingangssignal für den Timer berücksichtigt werden.

Es ist weiterhin von Vorteil, wenn der Empfänger eine Frequenzversatz-Erfassungseinrichtung zum Detektieren eines Frequenzversatzes zwischen der lokal erzeugten Frequenz und der Trägerfrequenz des empfangenen Signals und zusätzlich eine Frequenzregelungseinrichtung zum Kompensieren dieses Frequenzversatzes aufweist. Vorteilhafterweise berücksichtigt die Frequenzregelungseinrichtung bei der Erzeugung des zweiten Regelungssignals nicht nur den Frequenzversatz, sondern auch das zweite Steuersignal, um auf diese Weise auch einer eventuell erforderlichen neuen Voreinstellung des Referenzoszillators auf eine neue voreingestellte Referenzfrequenz zu genügen

Vorteilhafterweise wird der erwartete und der tatsächliche Empfangszeitpunkt des empfangenen Signals in bezug auf in dem empfangenen Signal enthaltenen Testsequenzen mit vorgegebenen Zeitabständen definiert.

Die Aufgabe der Erfindung wird Weiterhin durch das in den Patentansprüchen 6 bis 9 definierte Verfahren gelöst. Die Vorteile dieses Verfahrens entsprechen den oben für den Empfänger genannten Vorteilen.

Der Beschreibung sind insgesamt vier Figuren beigefügt, wobei

Fig. 1    einen Empfänger gemäß einem ersten Ausführungsbeispiel der vorliegenden Erfindung;

Fig. 2    einen Empfänger gemäß einem zweiten Ausführungsbeispiel der Erfindung;

Fig. 3    einen Empfänger gemäß einem ersten Ausführungsbeispiel aus dem Stand der Technik;

und

Fig. 4    einen Empfänger gemäß einem zweiten Ausführungsbeispiel gemäß dem Stand der Technik

zeigen.

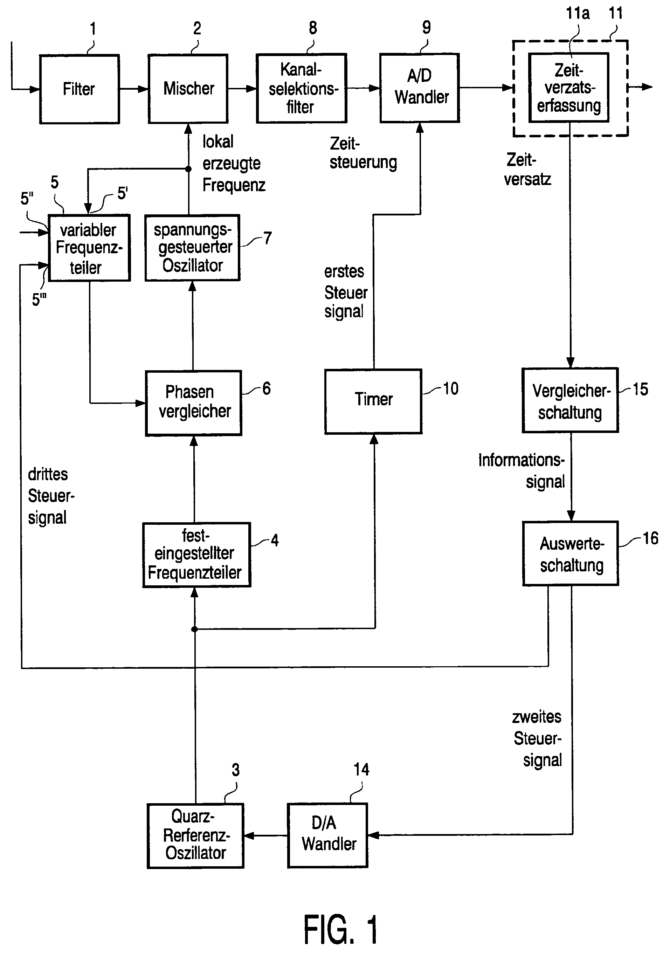

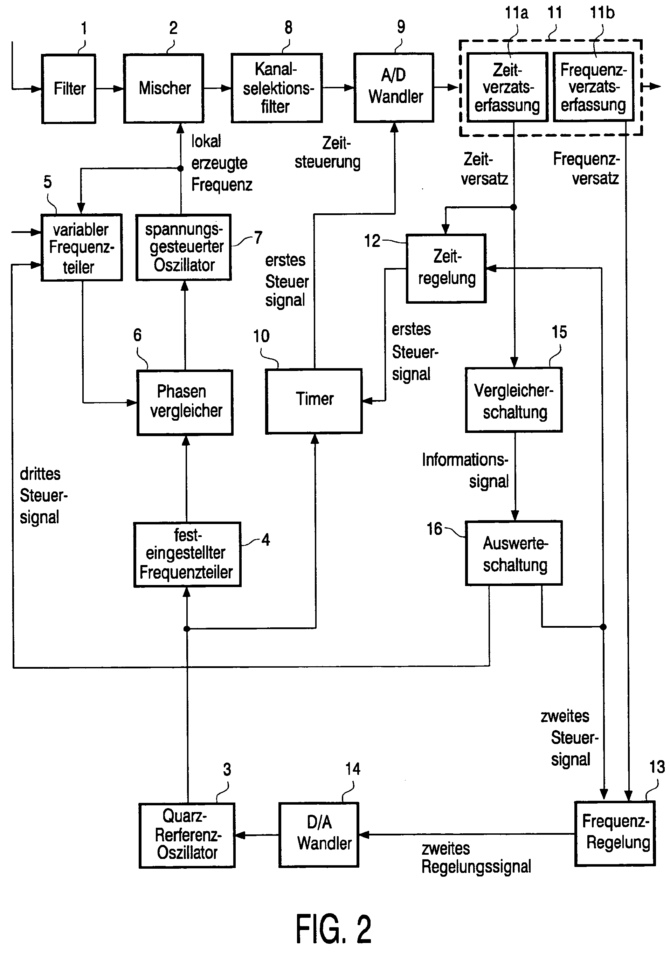

Es werden nachfolgend verschiedene Ausführungsformen des erfindungsgemäßen Empfängers unter Bezugnahme auf die Fig. 1 und 2 erläutert.

Fig 1 zeigt ein erstes Ausführungsbeispiel der Erfindung wobei der Aufbau und die Funktionsweise der Komponenten 1 bis 11 des Empfängers grundsätzlich denen des oben unter Bezugnahme auf Fig 3 beschriebenen Empfängers aus dem Stand der Technik entspricht.

Der Empfänger gemäß Fig 1 weist zusätzlich eine Zeitversatz-Erfassung 11a, eine Vergleicherschaltung 15, eine Auswerteschaltung 16 und einen D/A-Wandler 14 auf, deren Funktion und deren Zusammenspiel mit den Komponenten aus dem Stand der Technik nachfolgend beschrieben werden.

Wie oben beschrieben, kann es als Ergebnis einer Anfangssynchronisation nach dem Stand der Technik passieren, dass der spannungsgesteuerte Oszillator 7 in dem Empfänger zwar eine richtige lokale Frequenz erzeugt, allerdings unter Annahme einer falschen Kanalzuordnung Diese falsche Kanalzuordnung bedeutet, dass, wie oben beschrieben, der Referemoszillator eine Frequenzabweichung aufweist, welche durch einen gleichzeitig falsch eingestellten Teilungsfaktor bei dem variablen Frequenzteiler 5 derart kompensiert wird, dass trotzdem am Ausgang des Oszillators 7 die richtige Frequenz erzeugt wird.

Die Abweichung der Referenzfrequenz von der Nominalreferenzfrequenz macht sich aufgrund der beschriebenen starren Kopplung von Frequenz- und Zeitbasis in dem Empfänger insbesondere in einer Verschiebung der Zeitbasis bemerkbar. Diese Verschiebung der Zeitbasis entspricht einem Zeitversatz zwischen einem erwarteten und einem tatsächlichen Empfangszeitpunkt des empfangenen Signals. Dieser Zeitversatz tritt sowohl bei dem Empfänger nach dem Stand der Technik gemäß Fig 3, wie auch bei dem erfindungsgemäßen Empfänger gemäß Fig 1 statt. Im Unterschied zum Stand der Technik wird dieser Zeitversatz allerdings erfindungsgemäß durch die Zeitversatz-Erfassungseinrichtung 11a, welche zB. in dem Entzerrer 11 implementiert sein kann, erfasst.

Die beschriebene Kopplung zwischen Frequenz und Zeitbasis ist bereits bei Erzeugung des empfangenen Signals in einem Sender, also vor Empfang durch den Empfänger, gegeben und wird während der Funkausbreitung des Signals nur geringfügig gestört. Es ist deshalb davon auszugeben, dass eine in dem Empfänger beobachtete Störung dieser Kopplung in Form einer vor- oder nacheilenden Systemzeit bzw. in Form eines festgestellten Zeitversatzes ein eindeutiger Indikator für eine falsche Kanalzuordnung bei der zuvor erfolgten Anfangssynchronisation ist.

Anders ausgedrückt dient ein festgestellter Zeitversatz, dann wenn er einen vorbestimmten Schwellenwert überschreitet, als Indikator für ein falsch eingestelltes Teilerverhältnis bei dem variablen Frequenzteiler 5. Zur Feststellung, ob der gemessene Zeitversatz den vorbestimmten Schwellenwert unter- oder überschreitet, ist erfindungsgemäß die Vergleicherschaltung 15 vorgesehen. Liegt der Zeitversatz unterhalb des Schwellenwertes, ist also die Kopplung zwischen Frequenz und Zeitbasis nur geringfügig gestört, so wird angenommen, dass dies möglicherweise während der Funkausbreitung passiert ist und es kann deshalb nicht zwangsläufig auf eine falsche Kanalzuordnung innerhalb des Empfängers geschlossen werden. Ist der festgestellte Zeitversatz andererseits größer als der Schwellenwert, d.h. größer als dass er nur durch eine gestörte Funkausbreitung hätte verursacht werden können, so wird erfindungsgemäß angenommen, dass eine falsche Kanalzuordnung vorliegt.

Eine derartige Auswertung des Zeitversatzes erfolgt in der erfindungsgemäßen Auswerteschaltung 16. Sie berechnet aufgrund der Größe des festgestellten Zeitversatzes ein korrigiertes Teilerverhältnis und übermittelt dieses in Form eines dritten Steuersignals an den variablen Frequenzteiler 5. Die Auswerteschaltung 16 berechnet weiterhin aufgrund des festgestellten Zeitversatzes eine korrigierte Referenzfrequenz und übermittelt diese in Form eines zweiten Steuersignals über den Digital/Analog D /A-Wandler 14 an den Referenzoszillator 3. Die Korrektur des Teilerverhältnisses über den Eingang 5''' des variablen Frequenzteilers 5 und die Korrektur der Referenzfrequenz über das zweite Steuersignal werden idealerweise genau gegenläufig und gleichzeitig vorgenommen, so dass sich die von dem spannungsgesteuerten Oszillator 7 erzeugte richtige lokale Frequenz möglichst nicht ändert; auf diese Weise wird eine gute Synchronisation des Empfängers auf die Trägerfrequenz des gewünschten Kanals in dem empfangenen Signal sichergestellt.

Fig. 2 zeigt ein zweites Ausführungsbeispiel des erfindungsgemäßen Empfängers, welches hinsichtlich seines Aufbaues und seiner grundsätzlichen Funktionsweise dem aus dem Stand der Technik bekannten Empfänger gemäß Fig. 4 entspricht; insbesondere gilt dies auch für die Zeitregelung 12 und die Frequenzregelung 13.

Der erfindungsgemäße Empfänger gemäß Fig. 2 weist jedoch im Unterschied zum Stand der Technik die Vergleicherschaltung 15 und die Auswerteschaltung 16 auf, deren Funktion bereits oben unter Bezugnahme auf Fig. 1 erläutert wurde. Bei dem zweiten Ausführungsbeispiel des Empfängers gemäß Fig. 2 dient das von der Auswerteschaltung 16 erzeugte zweite Steuersignal nun allerdings als zweite Eingangsgröße für sowohl die Zeitregelung 12 als auch für die Frequenzregelung 13. Auf diese Weise wird gewährleistet, dass sowohl das von der Zeitregelung 12 erzeugte erste Regelungssignal, wie auch das von der Frequenzregelung 13 erzeugte zweite Regelungssignal unter Berücksichtigung auf die zu korrigierende Referenzfrequenz des Referenzoszillators 3 erzeugt werden. Genauer gesagt, kann das zweite Regelungssignal gemäß diesem Ausführungsbeispiel sowohl zur Korrektur der Voreinstellung des Referenzoszillators 3 auf eine neue Referenzfrequenz, wie auch zur nachträglichen Ausregelung der neu voreingestellten Referenzfrequenz dienen.

Der Grundgedanke der Erfindung kann dadurch charakterisiert werden, dass die Trägerfrequenz der Hochfrequenzübertragung, d.h. die Trägerfrequenz des empfangenen Signals und die Frequenz des Symboltaktes der digitalen Modulation gemeinsam zur Synchronisation des Empfängers herangezogen werden.

Die Zeitversatzerfassungseinrichtung 11 stellt die Verschiebung des Abtastzeitpunktes der Symbole gegenüber der jeweils idealen Position fest und meldet einen über genügend lange Zeit gemittelten Zeitversatz sowohl an die Zeitregelung 12 als auch an die Vergleicherschaltung 15. Ein kleiner Zeitversatz wird allein durch die Zeitregelung 12 nach dem Stand der Technik zur Regeneration des Symboltaktes verwendet. Wird jedoch in der Vergleicherschaltung 15 ein Schwellenwert überschritten, so werden in der Auswerteeinrichtung 16 verbesserte Einstellungen des variablen Frequenzteilers 5 und des D/A-Wandlers 14 zur Steuerung des Referenzoszillators 3 berechnet. Ob die Zeitregelung 12 und die Frequenzregelung 13 bereits eingeschwungen sind, kann durch Empfangen und Auswerten einer dritten Synchronisationsmeldung in dem empfangenen Signal überprüft werden.

Nachdem das Teilerverhältnis des variablen Frequenzteilers 5 und die Referenzfrequenz des Referenzoszillators 3 in entweder dem ersten oder dem zweiten Ausführungsbeispiel des Empfängers korrigiert worden sind und eine Synchronisation des Empfängers erreicht worden ist, können die erfindungsgemäße Vergleicherschaltung 15 und die Auswerteschaltung 16 außer Funktion gesetzt werden. Eine erneute Aktivierung dieser Komponenten 15 und 16 ist erst dann wieder erforderlich, wenn ein erneuter vollständiger Aufbau des Funkempfanges erforderlich wird, also zB. nach einer längeren Unterbrechung aller Empfangsverbindungen.

**Patentansprüche**

1. Empfänger, insbesondere GSM Empfänger, mit Anfangssynchronisation zum Empfang eines analogen Signals mit einer gewünschten Trägerfrequenz, umfassend:

    einen Referenzoszillator (3) zum Erzeugen eines Referenzsignals mit einer Referenzfrequenz; eine Phasenregelschleife (5-7) mit einer variablen Frequenzteilerschaltung (5) zum Erzeugen einer lokalen Frequenz, welche zumindest näherungsweise der gewünschten Trägerfrequenz entspricht;
    einen Mischer (2) zum Erzeugen eines Mischsignals durch Mischen der lokal erzeugten mit der gewünschten Trägerfrequenz;
    einen Timer (10) zum Erzeugen eines ersten Steuersignals nach Maßgabe durch das Referenzsignal;
    einen A/D-Wandler (9) zum Empfangen und Digitalisieren des Mischsignals ab einem erwarteten Empfangszeitpunkt, welcher nach Maßgabe durch das erste Steuersignal vorgegeben ist; und
    eine Zeitversatz-Erfassungseinrichtung (11a) zum Empfangen des digitalisierten Mischsignals und zum Erzeugen eines Ausgangssignal, wobei das Ausgangssignal einen Zeitversatz zwischen dem erwarteten und dem tatsächlichen Empfangszeitpunkt des empfangenen Signal repräsentiert;
    **gekennzeichnet durch** eine Vergleichereinrichtung (15) zum Empfangen des Ausgangssignals der Zeitversatz-Erfassungseinrichtung (11a), zum Feststellen, ob der Zeitversatz einen vorgegebenen Schwellenwert überschreitet und zum Ausgeben eines entsprechenden Informationssignals; und
    eine Auswerteeinrichtung (16) zum Berechnen und Ausgeben einer korrigierten Referenzfrequenz in Form eines zweiten Steuersignals über einen D /A-Wandler (14) an den Referenzoszillator (3) und zum Berechnen und Ausgeben eines korrigierten Teilerverhältnisses in Form eines dritten Steuersignals an die variable Frequenzteilerschaltung (5), so dass der Referenzoszillator auf die korrigierte Referenzfrequenz und die Frequenzteilerschaltung auf das korrigierte Teilerverhältnis eingestellt sind, wobei die Berechnung und Ausgabe der korrigierten Referenzfrequenz und des korrigierten Teilerverhältnisses nur dann erfolgt, wenn der Zeitversatz nach Maßgabe **durch** das Informationssignal den Schwellenwert überschreitet.

2. Empfänger nach Anspruch 1,

**gekennzeichnet durch** eine Zeitregelungseinrichtung (12) zum Kompensieren des Zeitversatzes **durch** Erzeugen eines Regelungssignals nach Maßgabe **durch** das Ausgangssignal der Zeitversatz-Erfassungseinrichtung und zum Ausgeben des Regelungssignals an den Timer.

**3.** Empfänger nach Anspruch 2,
**dadurch gekennzeichnet,**
**dass** die Zeitregelungseinrichtung (12) das von der Auswneeinrichtung (16) ausgegebene 2. Steuersignal empfängt und bei der Erzeugung des Regelungssignals berücksichtigt.

**4.** Empfänger nach einem der Ansprüche 1-3,
**gekennzeichnet durch** eine Frequenzversatz-Erfassungseinrichtung (11b) zum Erzeugen eines Ausgangssignal, welches einen Frequenzversatz zwischen der lokal erzeugten Frequenz und
der Trägerfrequenz des empfangenen Signals repräsentiert; und **durch** eine Frequenzregslungseinrichtung (13) zum Kompensieren dieses Frequenzversatzes **durch** Erzeugen eines zweiten Regelungssignals im Ansprechen auf das Ausgangssignal der Frequenzversatz-Erfassungseinrichtung sowie auf das zweite Steuersignal und zum Ausgeben des zweiten Regelungssignals über den D /A-Wandler (14) an den Referenzoszillator zum Regeln der jeweils voreingestellten Referenzfrequenz.

**5.** Empfänger nach einem der Ansprüche 1-4,
**dadurch gekennzeichnet,**
**dass** der erwartete und der tatsächliche Empfangszeitpunkt des empfangenen Signals in Bezug auf Testsequenzen in dem empfangenen Signal definiert sind.

**6.** Verfahren zum anfängtichen Synchronisieren eines Empfängers auf die Trägerfrequenz eines gewünschten Kanals, mit folgenden Schritten:

Erzeugen einer Referenzfrequenz;
Erzeugen einer lokalen Frequenz aus der Referenzfrequenz mit Hilfe variabler Frequenzteilung, wobei die lokale Frequenz zumindest näherungsweise der Trägerfrequenz des gewünschten Kanals entspricht;
Mischen der lokal erzeugten mit der gewünschten Trägerfrequenz zum Erzeugen eines Mischsignals;
Erzeugen eines ersten Steuersignals aus der Referenzfrequenz, welches eine Zeitbasis für den Empfang des Mischsignals repräsentiert;
Ermitteln der Größe eines Zeitversatzes zwischen dem erwarteten Anfangszeitpunkt für den Empfang des Mischsignals und dem Zeitpunkt des tatsächlichen Auftretens des Mischsignals; Prüfen, ob der festgestellte Zeitversatz größer als ein vorgegebener Schwellenwert ist und in diesem Fall
Einstellen eines korrigierten Teilerverhältnisses für die variable Frequenzteilung und Voreinstellen einer korrigierten Referenzfrequenz

**7.** Verfahren nach Anspruch 6,
**gekennzeichnet durch** den Schritt, dass die Zeitbasis nach Maßgabe **durch** die Größe des Zeitversatzes regelt wird.

**8.** Verfahren nach Anspruch 7,
**dadurch gekennzeichnet,**
**dass** die Regelung der Zeitbasis zusätzlich unter Berücksichtigung der korrigierten Referenzfrequenz erfolgt.

**9.** Verfahren nach einem der Ansprüche 6-8,
**dadurch gekennzeichnet,**
**dass** es weiterhin einen schritt zum Ermitteln der Grö Eines frequenzersatzes zwischen der lokal erzeugten Frequenz und der gewünschten Trägerfrequenz und zum Regeln der jeweils eingestellten Referenzfrequenz nach Maßgabe durch den ermittelten Frequenzvetsatz aufweist.

**Claims**

**1.** A receiver, in particular a GSM receiver, with initial synchronization for receiving an analog signal with a desired carrier frequency, comprising:

a reference oscillator (3) for generating a reference signal with a reference frequency;
a phase locked loop (5-7) with a variable frequency divider circuit (5) for generating a local frequency which corresponds at least approximately to the desired carrier frequency;
a mixer (2) for generating a mixed signal by mixing the locally generated carrier frequency with the desired one;
a timer (10) for generating a first control signal as determined by the reference signal;
an A/D converter (9) for receiving and digitizing the mixed signal starting from an expected receiving instant which is predetermined by the first control signal; and
a time offset-detection device (11a) for receiving the digitized mixed signal and for generating an output signal, the output signal representing a time offset between the expected and the actual receiving instant of the received signal;
**characterized in that** there are provided a comparator (15) for receiving the output signal of the time offset-detection device (11a), in order to establish whether the time offset exceeds a prescribed threshold value, and to output a corresponding information signal; and
an evaluation device (16) for calculating and outputting a corrected reference frequency in the form of a second control signal, via a D/A converter (14), to the reference oscillator (3), and for calculating and outputting a corrected divider ratio in the form of a third control signal to the variable frequency divider circuit (5) such that the reference oscillator is set to the corrected reference frequency and the frequency divider circuit is set to the corrected divider ratio, the calculation and output of the corrected reference frequency and of the corrected divider ratio being performed only when the time offset exceeds the threshold value as determined by the information signal.

2. A receiver as claimed in claim 1, **characterized in that** there is provided a time regulation device (12) for compensating the time offset by generating a regulation signal as determined by the output signal of the time offset-detection device, and for outputting the regulation signal to the timer.

3. A receiver as claimed in claim 2, wherein the time regulation device (12) receives the second control signal output by the evaluation device (16), and takes account of it when generating the regulation signal.

4. A receiver as claimed in one of claims I to 3, **characterized in that** there are provided a frequency offset detection device (11b) for generating an output signal which represents a frequency offset between the locally generated frequency and the carrier frequency of the received signal, and a frequency regulation device (13) for compensating this frequency offset by generating a second regulation signal in response to the output signal of the frequency offset detection device and to the second control signal, and for outputting the second regulation signal via the D/A converter (14), to the reference oscillator in order to regulate the respective preset reference frequency.

5. A receiver as claimed in one of claims 1 to 4, wherein the expected and the actual receiving instant of the received signal are defined with reference to test sequences in the received signal.

6. A method for initial synchronization of a receiver with the carrier frequency of a desired channel, which method has the following steps:

generating a reference frequency;
generating a local frequency from the reference frequency with the aid of variable frequency division, the local frequency corresponding at least approximately to the carrier frequency of the desired channel;
mixing the locally generated carrier frequency with the desired one in order to generate a mixed signal;
generating a first control signal from the reference frequency, which control signal represents a time base for receiving the mixed signals;
determining the magnitude of a time offset between the expected receiving instant for the reception of the mixed signal and the instant of the actual occurrence of the mixed signal; checking whether the established time offset is greater than a prescribed threshold value, and in that case
setting a corrected divider ratio for the variable frequency division and
presetting a corrected reference frequency.

7. A method as claimed in claim 6, **characterized in that** is includes a step in which the time base is regulated as determined by the magnitude of the time offset.

8. A method as claimed in claim 7, wherein the regulation of the time base is performed additionally while taking account of the corrected reference frequency.

9. A method as claimed in one of claims 6 to 8, **characterized in that** it also includes a step for determining the magnitude of a frequency offset between the locally generated frequency and the desired carrier frequency, and for regulating the respective set reference frequency as determined by the determined frequency offset.

**Revendications**

1. Récepteur, en particulier récepteur GSM, avec synchronisation initiale pour la réception d'un signal analogique avec une fréquence porteuse souhaitée, comprenant :

   un oscillateur de référence (3) pour la production d'un signal de référence avec une fréquence de référence ;
   une boucle de réglage de phase (5-7) avec un circuit diviseur de fréquence variable (5) pour la production d'une fréquence locale qui correspond, du moins approximativement, à la fréquence porteuse souhaitée;
   un mélangeur (2) pour la production d'un signal de mélange par mélange de la fréquence porteuse produite localement avec la fréquence porteuse souhaitée;
   un rythmeur (10) pour la production d'un premier signal de commande en fonction du signal de référence;
   un convertisseur A/N (9) pour la réception et la numérisation du signal de mélange à partir d'un moment de réception attendu qui est préalablement déterminé en fonction du premier signal de commande; et
   un dispositif de détection du décalage temporel (11a) pour la réception du signal de mélange numérisé et pour la production d'un signal de sortie, le signal de sortie représentant un décalage temporel entre le signal attendu et le moment de réception effectif du signal reçu ;
   **caractérisé par** un dispositif comparateur (15) pour la réception du signal de sortie du dispositif de détection du décalage temporel (11a) pour déterminer si le décalage temporel dépasse une valeur seuil préalablement déterminée et pour sortir un signal d'information correspondant ;
   un dispositif d'évaluation (16) pour le calcul et la sortie d'une fréquence de référence corrigée sous la forme d'un deuxième signal de commande par l'intermédiaire d'un convertisseur N/A (14) sur l'oscillateur de référence et pour le calcul et la sortie d'un rapport diviseur corrigé sous la forme d'un troisième signal de commande sur le circuit variable diviseur de fréquence (5) de telle sorte que l'oscillateur de référence soit réglé sur la fréquence de référence corrigée et le circuit diviseur de fréquence sur le rapport diviseur corrigé, le calcul et la sortie de la fréquence de référence corrigée et du rapport diviseur corrigé se produisant seulement lorsque le décalage temporel dépasse la valeur seuil en fonction du signal d'information.

2. Récepteur selon la revendication 1,
   **caractérisé par** un dispositif de réglage temporel (12) pour la compensation du décalage temporel par production d'un signal de réglage en fonction du signal de sortie du dispositif de détection du décalage temporel et pour la sortie du signal de réglage à hauteur du rythmeur.

3. Récepteur selon la revendication 2,
   **caractérisé en ce**
   **que** le circuit de réglage temporel (12) reçoit le deuxième signal de commande délivré par le dispositif d'évaluation (16) et en tient compte lors de la production du signal de réglage.

4. Récepteur selon l'une des revendications 1-3,
   **caractérisé par** un dispositif de détection du décalage de fréquence (1 lb) pour la production d'un signal de sortie qui représente un décalage de fréquence entre la fréquence produite localement et la fréquence porteuse du signal reçu; et par un dispositif de réglage de fréquence (13) pour compenser ce décalage de fréquence par production d'un deuxième signal de réglage en réponse au signal de sortie du dispositif de détection du décalage de fréquence ainsi qu'au deuxième signal de commande et pour la sortie du deuxième signal de réglage par l'intermédiaire du convertisseur N/A (14) à hauteur de l'oscillateur de référence pour le réglage de la fréquence de référence préalablement réglée.

5. Récepteur selon l'une des revendications 1-4,
   **caractérisé en ce**
   **que** les moments de réception attendus et effectifs du signal reçu sont définis par rapport aux séquences de test dans le signal reçu.

6. Procédé de synchronisation initiale d'un récepteur sur la fréquence porteuse d'un canal souhaité, comportant les étapes suivantes:

production d'une fréquence de référence ;

production d'une fréquence locale à partir de la fréquence de référence à l'aide d'une division de fréquence variable, la fréquence locale correspondant, du moins approximativement, à la fréquence porteuse du canal souhaité;

mélange de la fréquence porteuse produite localement avec la fréquence porteuse souhaitée pour la production d'un signal de mélange;

production d'un premier signal de commande en fonction du signal de référence qui représente une base temporelle pour la réception du signal de mélange;

détermination de la grandeur d'un décalage temporel entre le moment initial attendu pour la réception du signal de mélange et le moment de l'apparition effective du signal de mélange; vérification si le décalage temporel fixé est supérieur à une valeur-seuil préalablement déterminée et, dans ce cas,

réglage d'un rapport diviseur corrigé pour la division de fréquence variable et réglage préalable d'une fréquence de référence corrigée.

7. Procédé selon la revendication 6,
   **caractérisé par** l'étape que la base temporelle est réglée en fonction de la grandeur du décalage temporel.

8. Procédé selon la revendication 7,
   **caractérisé en ce que** le réglage de la base temporelle est effectué par ailleurs en prenant en considération la fréquence de référence corrigée.

9. Procédé selon l'une des revendications 6-8,
   **caractérisé en ce**
   **qu'**il présente par ailleurs une étape de détermination de la grandeur d'un décalage de fréquence entre la fréquence produite localement et la fréquence porteuse souhaitée et de réglage de la fréquence de référence respectivement réglée en fonction du décalage de fréquence déterminé.

FIG. 1

FIG. 2

FIG. 3   Stand der Technik

FIG. 4  Stand der Technik